# EUROPEAN PATENT APPLICATION

(11) **EP 2 228 792 A2**
(43) Date of publication of application: **15.09.2010**
(21) Application number: 10167973.6
(22) Date of filing: 21.03.2005
(51) Int. Cl.: G10L 19/00

(54) **Scalable lossless audio codec and authoring tool**

(30) Priority: 25.03.2004 US 556183 P; 04.08.2004 US 911062; 04.08.2004 US 911067
(62) Divisional of application: 05728310.3
(71) Applicant: DTS, Inc., Agoura Hills, CA 91301 (US)
(72) Inventor: Fejzo, Zoran, Los Angeles, CA 90049 (US)
(74) Representative: South, Nicholas Geoffrey

(57) **Abstract**

An audio codec losslessly encodes audio data into a sequence of analysis windows in a scalable bitstream. This is suitably done by separating the audio data into MSB and LSB portions and encoding each with a different lossless algorithm. An authoring tool compares the buffered payload to an allowed payload for each window and selectively scales the losslessly encoded audio data, suitably the LSB portion, in the non-conforming windows to reduce the encoded payload, hence buffered payload. This approach satisfies the media bit rate and buffer capacity constraints without having to filter the original audio data, reencode or otherwise disrupt the lossless bitstream.

## Description

### CROSS-REFERENCE TO RELATED APPLICATIONS

This application claims benefit of priority under 35 U.S.C. 119(e) to U.S. Provisional Application No. 60/566,183 entitled "Backward Compatible Lossless Audio Codec" filed on March 25, 2004, the entire contents of which are incorporated by reference.

### BACKGROUND OF THE INVENTION

### Field of the Invention

This invention relates to lossless audio codecs and more specifically to a scalable lossless audio codec and authoring tool.

### Description of the Related Art

Numbers of low bit-rate lossy audio coding systems are currently in use in a wide range of consumer and professional audio playback products and services. For example, Dolby AC3 (Dolby digital) audio coding system is a world-wide standard for encoding stereo and 5.1 channel audio sound tracks for Laser Disc, NTSC coded DVD video, and ATV, using bit rates up to 640kbit/s. MPEG I and MPEG II audio coding standards are widely used for stereo and multi-channel sound track encoding for PAL encoded DVD video, terrestrial digital radio broadcasting in Europe and Satellite broadcasting in the US, at bit rates up to 768kbit/s. DTS (Dig ital Theater Systems) Coherent Acoustics audio coding system is frequently used for studio quality 5.1 channel audio sound tracks for Compact Disc, DVD video, Satellite Broadcast in Europe and Laser Disc and bit rates up to 1536kbit/s.

An improved codec offering 96 kHz bandwidth and 24 bit resolution is disclosed in U.S. patent No. 6,226,616 (also assigned to Digital Theater Systems, Inc.). That patent employs a core and extension methodology in which the traditional audio coding algorithm constitutes the 'core' audio coder, and remains unaltered. The audio data necessary to represent higher audio frequencies (in the case of higher sampling rates) or higher sample resolution (in the case of larger word lengths), or both, is transmitted as an 'extension' stream. This allows audio content providers to include a single audio bit stream that is compatible with different types of decoders resident in the consumer equipment base. The core stream will be decoded by the older decoders which will ignore the extension data, while newer decoders will make use of both core and extension data streams giving higher quality sound reproduction. However, this prior approach does not provide truly lossless encoding or decoding. Although the system of U.S. patent 6,226,216 provides superior quality audio playback, it does not provide "lossless" performance.

Recently, many consumers have shown interest in these so-called "lossless" codecs. "Lossless" codecs rely on algorithms which compress data without discarding any information. As such, they do not employ psychoacoustic effects such as "masking". A lossless codec produces a decoded signal which is identical to the (digitized) source signal. This performance comes at a cost: such codecs typically require more bandwidth than lossy codecs, and compress the data to a lesser degree.

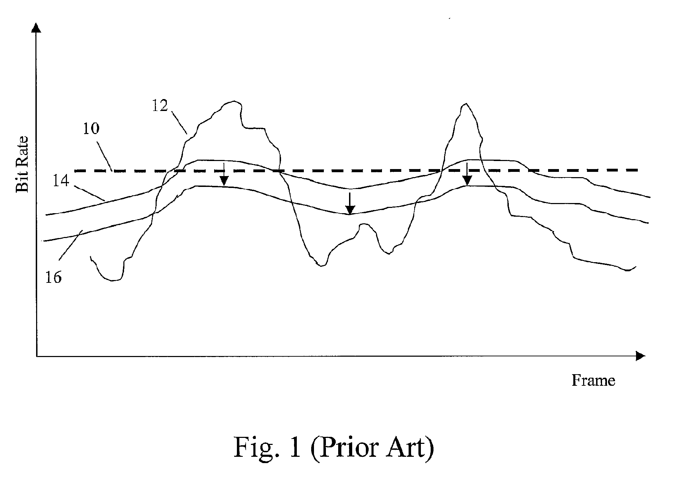

The lack of compression can cause a problem when content is being authored to a disk, CD, DVD, etc., particularly in cases of highly un-correlated source material or very large source bandwidth requirements. The optical properties of the media establish a peak bit rate for all content that can not be exceeded. As shown in Figure 1, a hard threshold 10, e.g., 9.6 Mbps for DVD audio, is typically established for audio so that the total bit rate does not exceed the media limit.

The audio and other data is laid out on the disk to satisfy the various media constraints and to ensure that all the data that is required to decode a given frame will be present in the audio decoder buffer. The buffer has the effect of smoothing the frame-to-frame encoded payload (bit rate) **12,** which can fluctuate wildly from frame-to-frame, to create a buffered payload **14,** i.e. the buffered average of the frame-to-frame encoded payload. If the buffered payload **14** of the lossless bitstream for a given channel exceeds the threshold at any point the audio input files are altered to reduce their information content. The audio files may be altered by reducing the bit-depth of one or more channels such as from 24-bit to 22-bit, filtering a channel's frequency bandwidth to lowpass only, or reducing the audio bandwidth such as by filtering information above 40 kHz when sampling at 96 kHz. The altered audio input files are re-encoded so that the payload **16** never exceeds the threshold **10.** An example of this process is described in the SurCode MLP - Owner's Manual pp. 20-23.

This is a very computationally and time inefficient process. Furthermore, although the audio encoder is still lossless, the amount of audio content that is delivered to the user has been reduced over the entire bitstream. Moreover, the alteration process is inexact, if too little information is removed the problem may still exist, if too much information is removed audio data is needlessly discarded. In addition, the authoring process will have to be tailored to the specific optical properties of the media and the buffer size of the decoder.

### SUMMARY OF THE INVENTION

The present invention provides an audio codec that generates a lossless bitstream and an authoring tool that selectively discards bits to satisfy media, channel, decoder buffer or playback device bit rate constraints without having to filter the audio input files, reencode or to otherwise disrupt the lossless bitstream.

This is accomplished by losslessly encoding the audio data in a sequence of analysis windows into a scalable bitstream, comparing the buffered payload to an allowed payload for each window, and selectively scaling the losslessly encoded audio data in the non-conforming windows to reduce the encoded payload, hence the buffered payload thereby introducing loss.

In an exemplary embodiment, the audio encoder separates the audio data into most significant bit (MSB) and least significant bit (LSB) portions and encodes each with a different lossless algorithm. An authoring tool writes the MSB portions to a bitstream, writes the LSB portions in the conforming windows to the bitstream, and scales the lossless LSB portions of any non-conforming frames to make them conform and writes the now lossy LSB portions to the bitstream. The audio decoder decodes the MSS and LSB portions and reassembles the PCM audio data.

The audio encoder splits each audio sample into the MSB and LSB portions, encodes the MSB portion with a first lossless algorithm, encodes the LSB portion with a second lossless algorithm, and packs the encoded audio data into a scalable, lossless bitstream. The boundary point between the MSB and LSB portions is suitably established by the energy and/or maximum amplitude of samples in an analysis window. The LSB bit widths are packed into the bitstream. The LSB portion is preferably encoded so that some or all of the LSBs may be selectively discarded. Frequency extensions may be similarly encoded with MSB/LSB or entirely encoded as LSBs.

An authoring tool is used to lay out the encoded data on a disk (media). The initial layout corresponds to the buffered payload. The tool compares the buffered payload to the allowed payload for each analysis window to determine whether the layout requires any modification. If not, all of the lossless MSB and LSB portions of the lossless bitstream are written to a bitstream and recorded on the disk. If yes, the authoring tool scales the lossless bitstream to satisfy the constraints. More specifically, the tool writes the lossless MSB and LSB portion for all of the conforming windows and the headers and lossless MSB portions for the non-conforming to a modified bitstream. Based on a prioritization rule, for each non-conforming window the authoring tool then determines how many of the LSBs to discard from each audio sample in the analysis window for one ore more audio channels and repacks the LSB portions into the modified bitstream with their modified bit widths. This is repeated for only those analysis windows in which the buffered payload exceeds the allowed payload.

A decoder receives the authored bitstream via the media or transmission channel. The audio data is directed to a buffer, which does not overflow on account of the authoring, and in turn provides sufficient data to a DSP chip to decode the audio data for the current analysis window. The DSP chip extracts the header information and extracts, decodes and assembles the MSB portions of the audio data. If all of the LSBs were discarded during authoring, the DSP chip translates the MSB samples to the original bit width word and outputs the PCM data. Otherwise, the DSP chip decodes the LSB portions, assembles the MSB & LSB samples, translates the assembled samples to the original bit width word and outputs the PCM data.

These and other features and advantages of the invention will be apparent to those skilled in the art from the following detailed description of preferred embodiments, taken together with the accompanying drawings, in which:

### BRIEF DESCRIPTION OF THE DRAWINGS

FIG. 1, as described above, is a plot of bit rate and payload for a lossless audio channel versus time;
FIG. 2 is a block diagram of a lossless audio codec and authoring tool in accordance with the present invention;
FIG. 3 is a simplified flowchart of the audio coder;
FIG. 4 is a diagram of an MSB/LSB split for a sample in the lossless bitstream;
FIG. 5 is a simplified flowchart of the authoring tool;
FIG. 6 is a diagram of an MSB/LSB split for a sample in the authored bitstreams;
FIG. 7 is a diagram of a bitstream including the MSB and LSB portions and header information;
FIG. 8 is a plot of payload for the lossless and authored bitstreams;
FIG. 9 is a simple block diagram of an audio decoder;
FIG. 10 is a flowchart of the decoding process;
FIG. 11 is a diagram of an assembled bitstream;
FIGs. 12-15 illustrate the bitstream format, encoding, authoring, and decoding for a particular embodiment; and
FIGs. 16a and 16b are block diagrams of the encoder and decoder for a scalable lossless codec that is backwards compatible with a lossy core encoder.

### DETAILED DESCRIPTION OF THE INVENTION

The present invention provides a lossless audio codec and authoring tool for selectively discarding bits to satisfy media, channel, decoder buffer or playback device bit rate constraints without having to filter the audio input files, reencode or to otherwise disrupt the lossless bitstream.

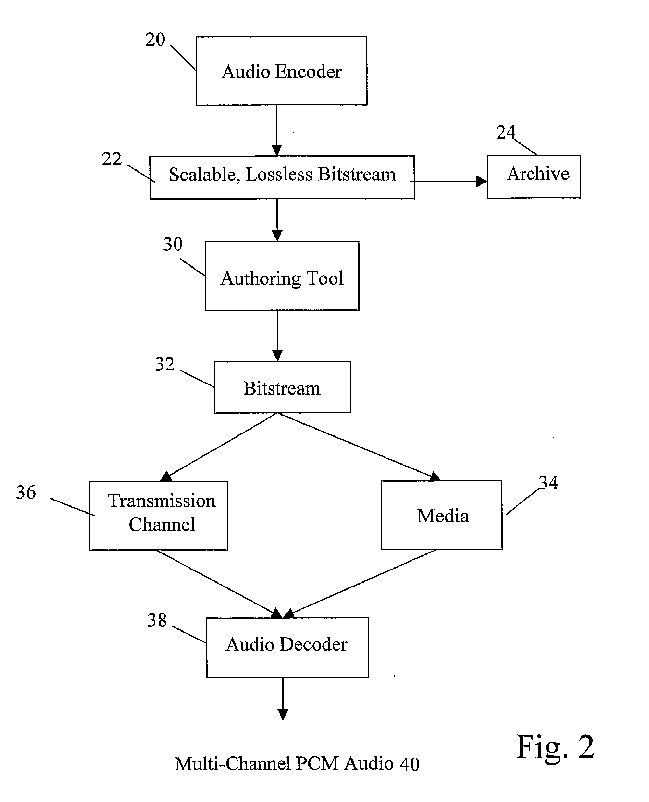

As shown in Figure 2, an audio encoder **20** losslessly encodes the audio data in a sequence of analysis windows and packs the encoded data and header information into a scalable, lossless bitstream **22,** which is suitably stored in an archive **24.** The analysis windows are typically frames of encoded data but as used herein the windows could span a plurality of frames. Furthermore, the analysis window may be refined into one or more segments of data inside a frame, one or more channel sets inside a segment, one or more channels in each channel set and finally one or more frequency extensions inside a channel. The scaling decisions for the bitstream can be very coarse (multiple frames) or more refined (per frequency extension per channel set per frame).

An authoring tool **30** is used to lay out the encoded data on a disk (media) in accordance with the decoder's buffer capacity. The initial layout corresponds to the buffered payload. The tool compares the buffered payload to the allowed payload for each analysis window to determine whether the layout requires any modification. The allowed payload is typically a function of the peak bit rate supported by a media (DVD disk) or transmission channel. The allowed payload may be fixed or allowed to vary if part of a global optimization. The authoring tool selectively scales the losslessly encoded audio data in the non-conforming windows to reduce the encoded payload, hence the buffered payload. The scaling process introduces some loss into the encoded data but is confined to only the non-conforming windows and is suitably just enough to bring each window into conformance. The authoring tool packs the lossless and lossy data and any modified header information into a bitstream **32.** The bitstream **32** is typically stored on a media **34** or transmitted over a transmission channel **36** for subsequent playback via an audio decoder **38,** which generates a single or multi-channel PCM (pulse code modulated) audio stream **40.**

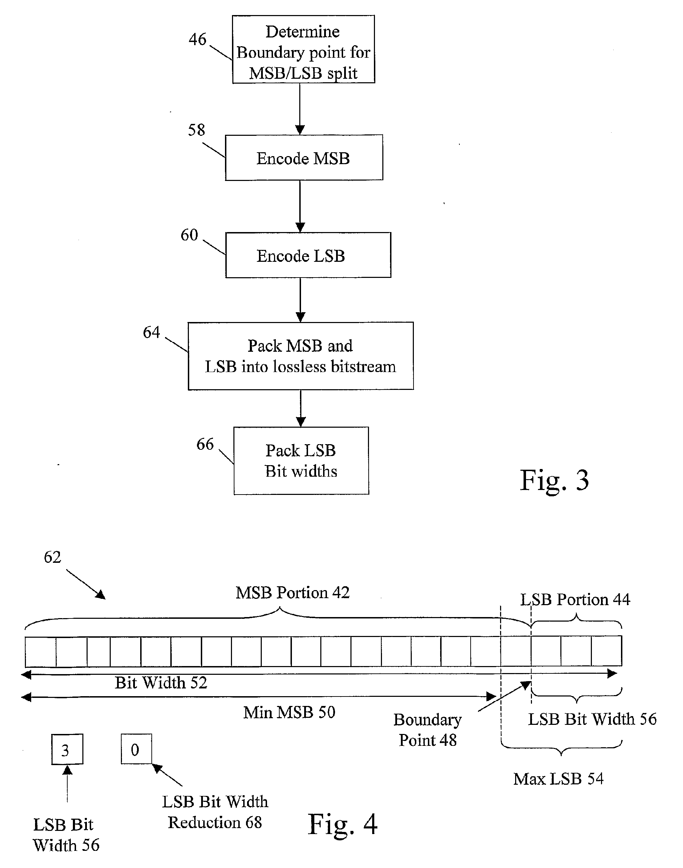

In an exemplary embodiment as shown in Figures 3 and 4, the audio encoder **20** splits each audio sample into a MSB portion **42** and a LSB portion **44** (step **46).** The boundary point **48** that separates the audio data is computed by first assigning a minimum MSB bit width (Min MSB) **50** that establishes a minimum coding level for each audio sample. For example, if the bit width **52** of the audio data is 20-bit the Min MSB might be 16-bit. It follows that the maximum LSB bit width (Max LSB) **54** is the Bit Width **52** minus the Min MSB **50.** The encoder computes a cost function, e.g. the L₂ or L_{∞} norms, for the audio data in the analysis window. If the cost function exceeds a threshold, the encoder calculates an LSB bit width **56** of at least one bit and no more than Max LSB. If the cost function does not exceed the threshold, the LSB bit width **56** is set to zero bits. In general, the MSB/LSB split is done for each analysis window. As describe above, this is typically one or more frames. The split can be further refined for each data segment, channel set, channel or frequency extension, for example. More refinement improves coding performance at the cost of additional computations and more overhead in the bitstream.

The encoder losslessly encodes the MSB portions (step **58)** and LSB portions (step **60)** with different lossless algorithms. The audio data in the MSB portions is typically highly correlated both temporally within any one channel and between channels. Therefore, the lossless algorithm suitably employs entropy coding, fixed prediction, adaptive prediction and joint channel decorrelation techniques to efficiently code the MSB portions. A suitable lossless encoder is described in copending application "Lossless Multi-Channel Audio Codec" filed on August 08, 2004, serial number 10/911067, which is hereby incorporated by reference. Other suitable lossless encoders include MLP (DVD Audio), Monkey's audio (computer applications), Apple lossless, Windows Media Pro lossless, AudioPak, DVD, LTAC, MUSICcompress, OggSquish, Philips, Shorten, Sonarc and WA. A review of many of these codecs is provided by Mat Hans, Ronald Schafer "Lossless Compression of Digital Audio" Hewlett Packard, 1999.

Conversely, the audio data in the LSB portion is highly uncorrelated, closer to noise. Therefore sophisticated compression techniques are largely ineffective and consume processing resources. Furthermore, to efficiently author the bitstream, a very simple lossless code using simplistic prediction of very low order followed by a simple entropy coder is highly desirable. In fact, the currently preferred algorithm is to encode the LSB portion by simply replicating the LSB bits as is. This will allow individual LSBs to be discarded without having to decode the LSB portion.

The encoder separately packs the encoded MSB and LSB portions into a scalable, lossless bitstream **62** so that they can be readily unpacked and decoded (step **64).** In addition to the normal header information, the encoder packs the LSB bit width **56** into the header (step **66).** The header also includes space for an LSB bit width reduction **68,** which is not used during encode. This process is repeated for each analysis window (frames, frame, segment, channel set or frequency extension) for which the split is recalculated.

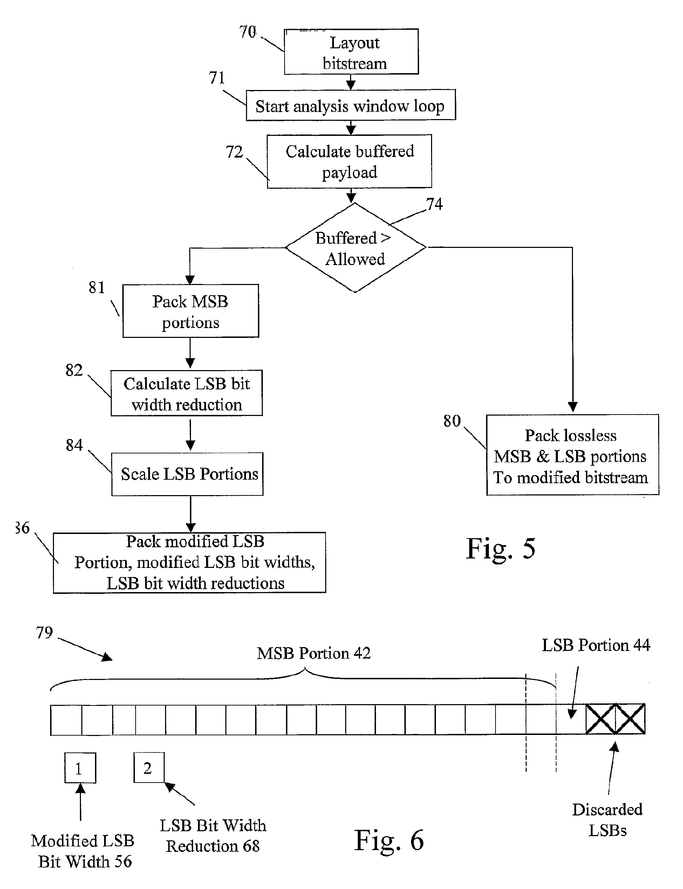

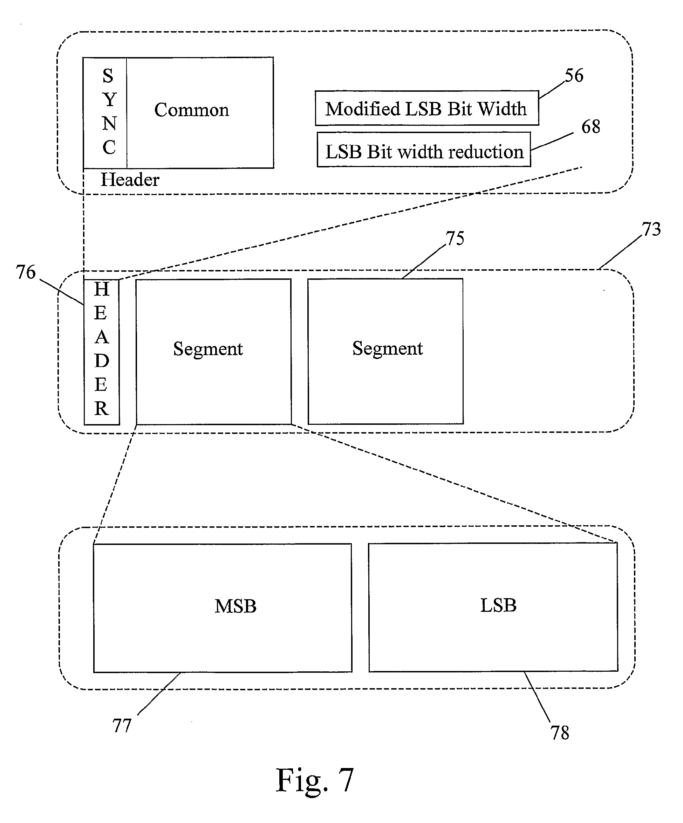

As shown in Figures 5, 6 and 7, the authoring tool **30** allows a user to make a first pass at laying out the audio and video bitstreams on the media in accordance with the decoder's buffer capacity (step **70)** to satisfy the media's peak bit rate constraint. The authoring tool starts the analysis window loop (step **71),** calculates an buffered payload (step **72)** and compares the buffered payload to the allowed payload for the analysis window **73** to determine whether the lossless bitstream requires any scaling to satisfy the constraints (step **74).** The allowed payload is determined by buffer capacity of the audio decoder and the peak bit rate of the media or channel. The encoded payload is determined by the bit width of the audio data and the number of samples in all of the data segments **75** plus the header **76.** If the allowed payload is not exceeded, the losslessly encoded MSB and LSB portions are packed into respective MSB and LSB areas **77** and **78** of the data segments **75** in a modified bitstream **79** (step **80).** If the allowed payload is never exceeded, the lossless bitstream is transferred directly to the media or channel.

If the buffered payload exceeds the allowed payload, the authoring tool packs the headers and losslessly encoded MSB portions **42** into the modified bitstream **79** (step **81).** Based on a prioritization rule, the authoring tool calculates an LSB bit width reduction **68** that will reduce the encoded payload, hence buffered payload to at most the allowed payload (step **82).** Assuming the LSB portions were simply replicated during lossless encoding, the authoring tool scales the LSB portions (step **84)** by preferably adding dither to each LSB portion so as to dither the next LSB bit past the LSB bit width reduction, and then shifting the LSB portion to the right by the LSB bit width reduction to discard bits. If the LSB portions were encoded, they would have to be decoded, dithered, shifted and reencoded. The tool packs the now lossy encoded LSB portions for the now conforming windows into the bitstream with the modified LSB bit widths **56** and the LSB bit width reduction **68** and a dither parameter (step **86).**

As shown in Figure 6, the LSB portion **44** has been scaled from a bit width of 3 to a modified LSB bit width **56** of 1-bit. The two discarded LSBs **88** match the LSB bit width reduction **68** of 2 bits. In the exemplary embodiment, the modified LSB bit width **56** and LSB bit width reduction **68** are transmitted in the header to the decoder. Alternately, either of these could be omitted and the original LSB bit width transmitted. Any one of the parameters is uniquely determined by the other two.

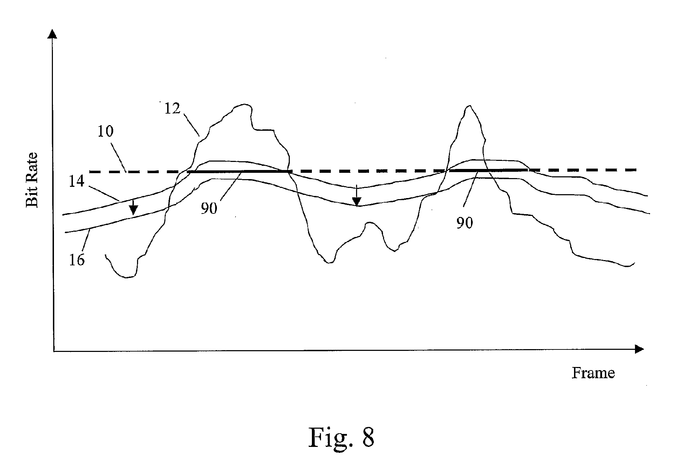

The benefits of the scalable, lossless encoder and authoring tool are best illustrated by overlaying the buffered payload **90** for the authored bitstream on Figure 1 as is done in Figure 8. Using the known approach of altering the audio files to remove content and then simply reencoding with the lossless coder, the buffered payload **14** was effectively shifted downward to a buffered payload **16** that is less than the allowed payload **10.** To ensure that the peak payload is less than the allowed payload, a considerable amount of content is sacrificed across the entire bitstream. By comparison, the buffered payload **90** replicates the original losslessly buffered payload **14** except in those few windows (frames) where the buffered payload exceeds the allowed payload. In these areas, the encoded payload, hence buffered payload is reduced just enough to satisfy the constraint and preferably no more. As a result, the payload capacity is utilized more efficiently and more content is delivered to the end user without having to alter the original audio files or reencode.

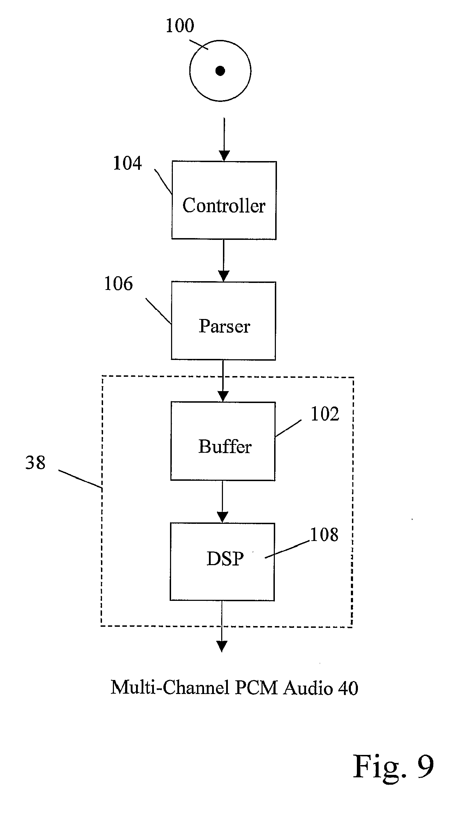

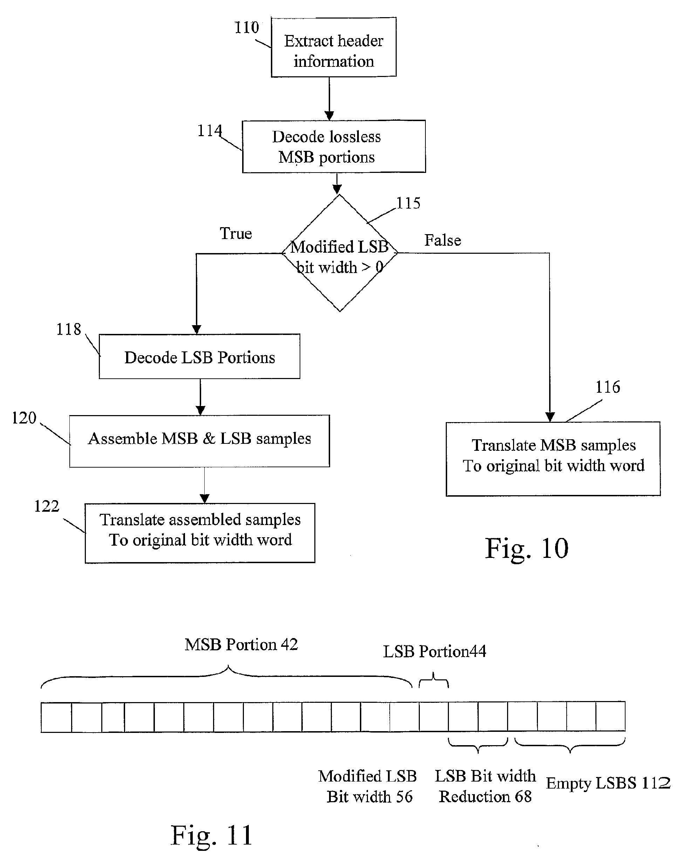

As shown in Figures 9, 10 and 11, the audio decoder **38** receives an authored bitstream via a disk **100.** The bitstream is separated into a sequence of analysis windows, each including header information and encoded audio data. Most of the windows include losslessly encoded MSB and LSB portions, the original LSB bit widths and LSB bit width reductions of zero. To satisfy the payload constraints set by the peak bit rate of the disk **100** and the capacity of the buffer **102,** some of the windows include the losslessly encoded MSB portions and lossy LSB portions, the modified bit widths of the lossy LSB portions, and the LSB bit width reductions.

A controller **104** reads the encoded audio data from the bitstream on the disk **100.** A parser **106** separates the audio data from the video and streams the audio data to the audio buffer **102,** which does not overflow on account of the authoring. The buffer in turn provides sufficient data to a DSP chip **108** to decode the audio data for the current analysis window. The DSP chip extracts the header information (step **110)** including the modified LSB bit widths **56,** LSB bit width reduction **68,** a number of empty LSBs **112** from an original word width and extracts, decodes and assembles the MSB portions of the audio data (step **114).** If all of the LSBs were discarded during authoring or original LSB bit width was 0 (step **115),** the DSP chip translates the MSB samples to the original bit width word and outputs the PCM data (step **116).** Otherwise, the DSP chip decodes the lossless and lossy LSB portions (step **118),** assembles the MSB & LSB samples (step **120),** and, using the header information, translates the assembled samples to the original bit width word (step **122).**

### Multi-Channel Audio Codec & Authoring Tool

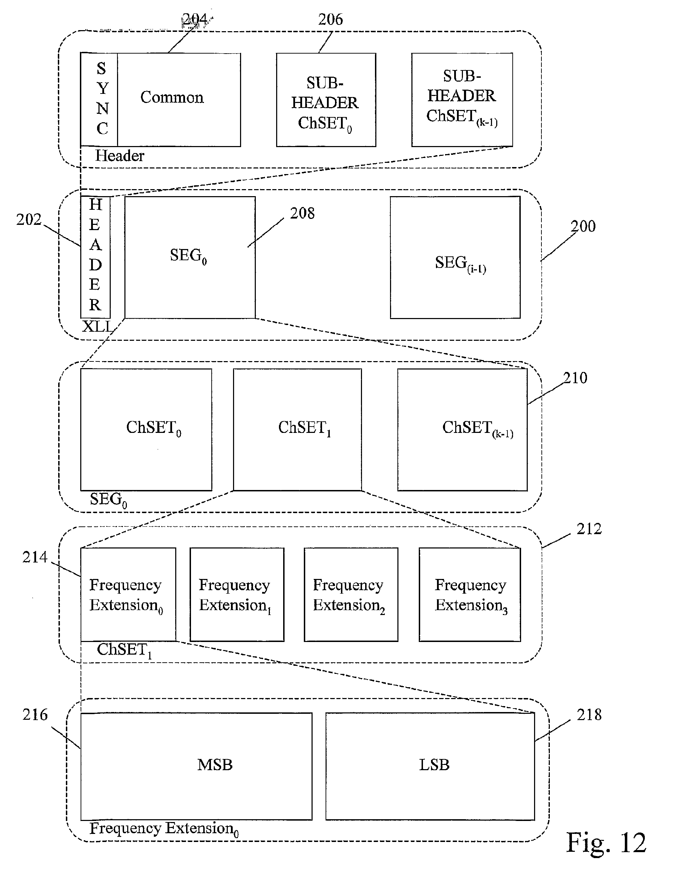

An exemplary embodiment of an audio codec and authoring tool for an encoded audio bitstream presented as a sequence of frames is illustrated in Figures 12-15. As shown in Figure 12, each frame **200** comprises a header **202** for storing common information **204** and sub-headers **206** for each channel set that store the LSB bit widths and LSB bit width reductions, and one or more data segments **208.** Each data segment comprises one or more channel sets **210** with each channel set comprising one or more audio channels **212.** Each channel comprises one or more frequency extensions **214** with at least the lowest frequency extension including encoded MSB and LSB portions **216, 218.** The bitstream has a distinct MSB and LSB split for each channel in each channel set in each frame. The higher frequency extensions may be similarly split or entirely encoded as LSB portions.

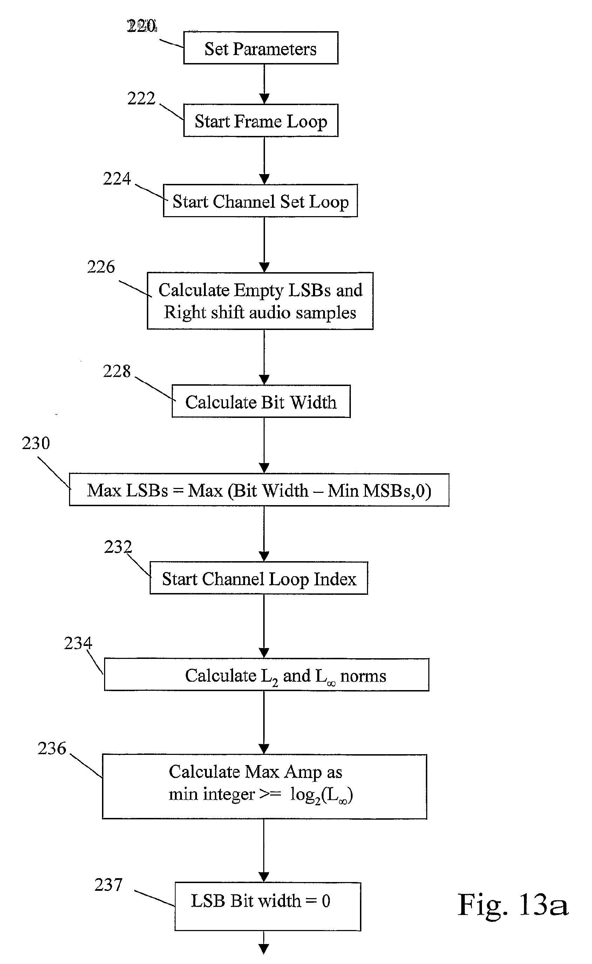

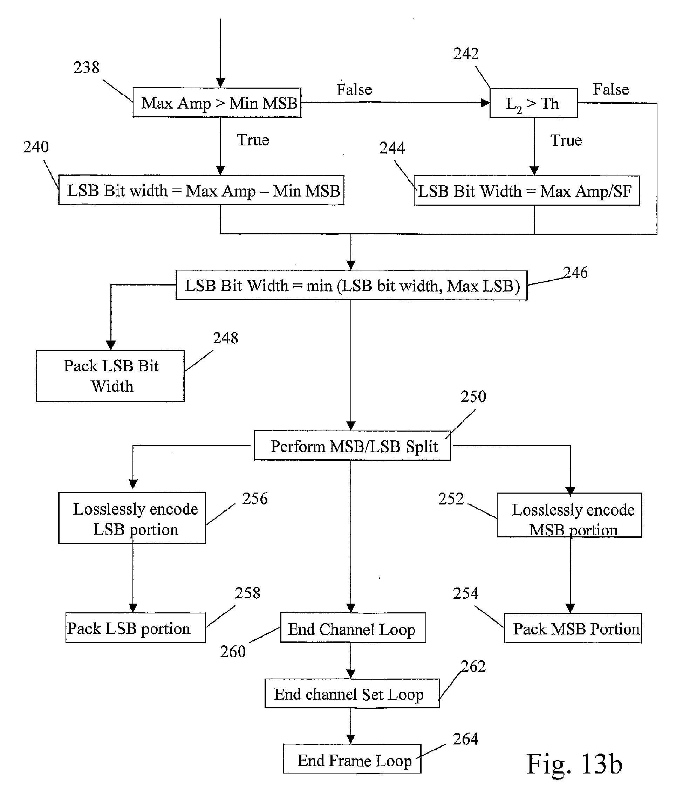

The scalable lossless bitstream from which this bitstream is authored is encoded as illustrated in Figures 13a and 13b. The encoder sets the bit width of the original word (24-bit), the Min MSB (16-bit), a threshold (Th) for the squared L2 norm and a scale factor (SF) for that norm (step **220).** The encoder starts the frame loop (step **222)** and the channel set loop (step **224).** Because the actual width of the audio data (20-bit) may be less than the original word width, the encoder calculates the number of empty LSBs (24-20=4)(min number of "0" LSBs in any PCM sample in the current frame) and right shifts every sample by that amount (step **226).** The bit width of the data is the original bit width (24) minus the number of empty LSBs (4) (step **228).** The encoder then determines the maximum number of bits (Max LSBs) that will allow to be encoded as part of the LSB portion as Max(Bit Width- Min MSB, 0) (step **230).** In the current example, the Max LSBS = 20- 16 = 4 bits.

To determine the boundary point for splitting the audio data into MSB and LSB portions, the encoder starts the channel loop index (step **232)** and calculates the L_{∞} norm as the maximum absolute amplitude of the audio data in the channel and the squared L2 norm as the sum of the squared amplitudes of the audio data in the analysis window (step **234**). The encoder sets a parameter Max Amp as the minimum integer greater than or equal to log₂(L_{∞}) (step **236**) and initializes the LSB bit width to zero (step **237**). If the Max Amp is greater than the Min MSB (step **238**), the LSB bit width is set equal to the difference of the Max Amp and Min MSB (step **240**)**.** Otherwise, if the L2 norm exceeds the Threshold (small amplitude but considerable variance) (step **242**)**,** the LSB bit width is set equal to the Max Amp divided by the Scale Factor, typically > 1 (step **244).** If both tests are false, the LSB bit width remains zero. In other words, to maintain the minimum encode quality, e.g. Min MSB, no LSBs are available. The encoder clips the LSB bit width at the Max LSB value (step **246)** and packs the value into the sub-header channel set (step **248).**

Once the boundary point has been determined, i.e. the LSB bit width, the encoder splits the audio data into the MSB and LSB portions (step **250).** The MSB portion is losslessly encoded using a suitable algorithm (step **252)** and packed into the lowest frequency extension in the particular channel in the channel set of the current frame (step **254).** The LSB portion is losslessly encoded using a suitable algorithm, e.g. simple bit replication (step **256)** and packed (step **258).**

This process is repeated for each channel (step **260)** for each channel set (step **262)** for each frame (step **264)** in the bitstream. Furthermore, the same procedure may be repeated for higher frequency extensions. However, because these extensions contain much less information, the Min MSB may be set to 0 so that it is all encoded as LSBs.

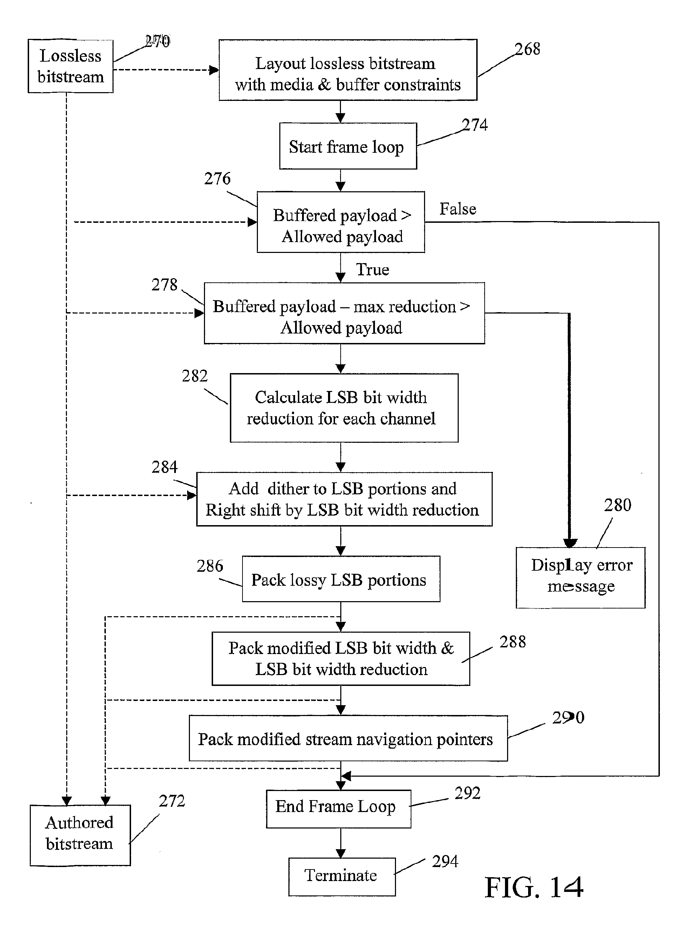

Once the scalable lossless bitstream is encoded for certain audio content, an authoring tool creates the best bitstream it can that satisfies the peak bit rate constraints of the transport media and the capacity of the buffer in the audio decoder. As shown in Figure 14, a user attempts to layout the lossless bitstream **268** on the media to conform to the bit rate and buffer capacity constrains (step **270).** If successful, the lossless bitstream **268** is written out as the authored bitstream **272** and stored on the media. Otherwise the authoring tool starts the frame loop (step **274)** and compares the buffered payload (buffered average frame-to-frame payload) to the allowed payload (peak bit rate) (step **276).** If the current frame conforms to the allowed payload, the losslessly encoded MSB and LSB portions are extracted from the lossless bitstream **268** and written to the authored bitstream **272** and the frame is incremented.

If the authoring tool encounters a non-conforming frame in which the buffered payload exceeds the allowed payload, the tool computes the maximum reduction that can be achieved by discarding all of the LSB portions in the channel set and subtracts it from the buffered payload (step **278).** If the minimum payload is still too big the tool displays an error message that includes the amount of excess date and frame number (step **280).** In this case either the Min MSB shall be reduced or the original audio files shall be altered and re-encoded.

Otherwise, the authoring tool calculates an LSB bit width reduction for each channel in the current frame based on a specified channel prioritization rule (step **282)** such that:
Bit Width Reduction[nCh] < LSB bit width[nCh] for nCh = 0, ... AllChannels -1, and
Buffered payload[nFr] - Σ (Bit Width Reduction[nCh} * NumSamplesin Frame) < Allowed Payload [nFr]

The reduction of the LSB bit widths by these values will ensure that the frame conforms to the allowed payload. This is done with a minimum amount of loss being introduced into the non-conforming frames and without otherwise affecting the lossless conforming frames.

The authoring tool adjusts the encoded LSB portions (assuming bit replication encoding) for each channel by adding dither to each LSB portion in the frame to dither the next bit and then right shifting by the LSB bit width reduction (step **284).** Adding dither is not necessary but is highly desirable in order to decorrelate the quantization errors and also make them decorrelated from the original audio signal. The tool packs the now lossy scaled LSB portions (step **286),** the modified LSB bit widths and LSB bit width reductions for each channel (step **288)** and the modified stream navigation points (step **290)** into the authored bitstream. If dither is added, a dither parameter is packed into the bitstream. This process is then repeated for each frame (step **292)** before terminating (step **294).**

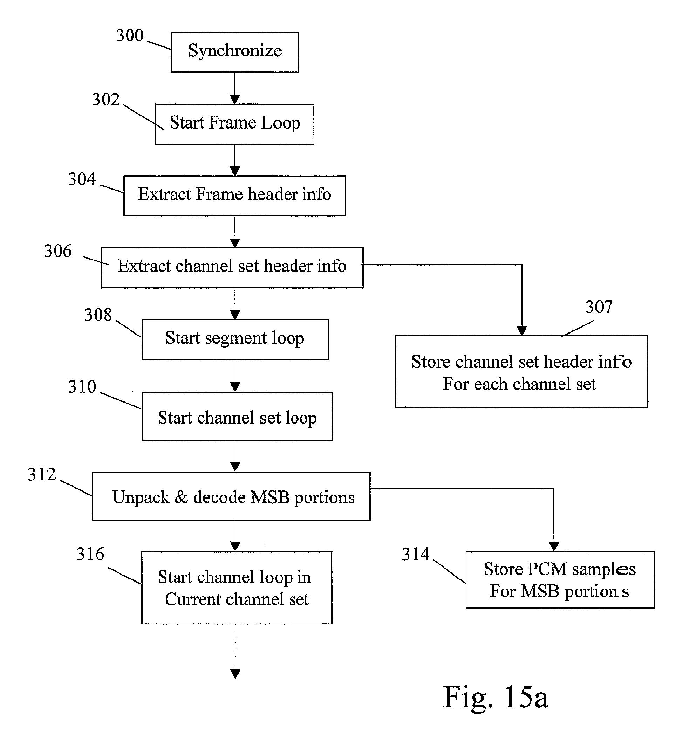

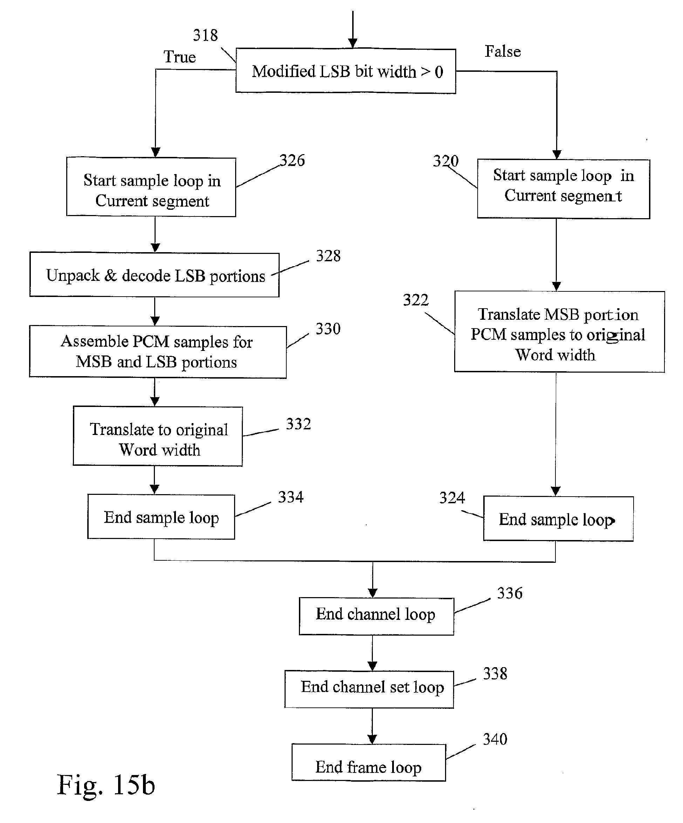

As shown in Figures 15a and 15b, a suitable decoder synchronizes to the bitstream (step **300)** and starts a frame loop (step **302).** The decoder extracts the frame header information including the number of segments, number of samples in a segment, number of channel sets, etc (step **304)** and extracts the channel set header information including the number channels in the set, number of empty LSBs, LSB bit width, LSB bit width reduction for each channel set (step **306)** and stores it for each channel set (step **307).**

Once the header information is available, the decoder starts the segment loop (step **308)** and channel set loop (step **310)** for the current frame. The decoder unpacks and decodes the MSB portions (step **312)** and stores the PCM samples (step **314).** The decoder then starts the channel loop in the current channel set (step **316)** and proceeds with the encoded LSB data.

If the modified LSB bit width does not exceed zero (step **318),** the decoder starts the sample loop in the current segment (step **320),** translates the PCM samples for the MSB portion to the original word width (step **322)** and repeats until the sample loop terminates (step **324).**

Otherwise, the decoder starts the sample loop in the current segment (step **326),** unpacks and decodes the LSB portions (step **328)** and assembles PCM samples by appending the LSB portion to the MSB portion (step **330).** The decoder then translates the PCM sample to the original word width using the empty LSB, modified LSB bit width and LSB bit width reduction information from the header (step **332)** and repeats the steps until the sample loop terminates (step **334).** To reconstruct the entire audio sequence, the decoder repeats these steps for each channel (step **336)** in each channel set (step **338)** in each frame (step **340).**

### Backward Compatible Scalable Audio Codec

The scalability properties can be incorporated into a backward compatible lossless encoder, bitstream format and decoder. A "lossy" core code stream is packed in concert with the losslessly encoded MSB and LSB portions of the audio data for transmission (or recording). Upon decoding in a decoder with extended lossless features, the lossy and lossless MSB streams are combined and the LSB stream is appended to construct a lossless reconstructed signal. In a prior-generation decoder, the lossless MSB and LSB extension streams are ignored, and the core "lossy" stream is decoded to provide a high-quality, multichannel audio signal with the bandwidth and signal-to-noise ratio characteristic of the core stream.

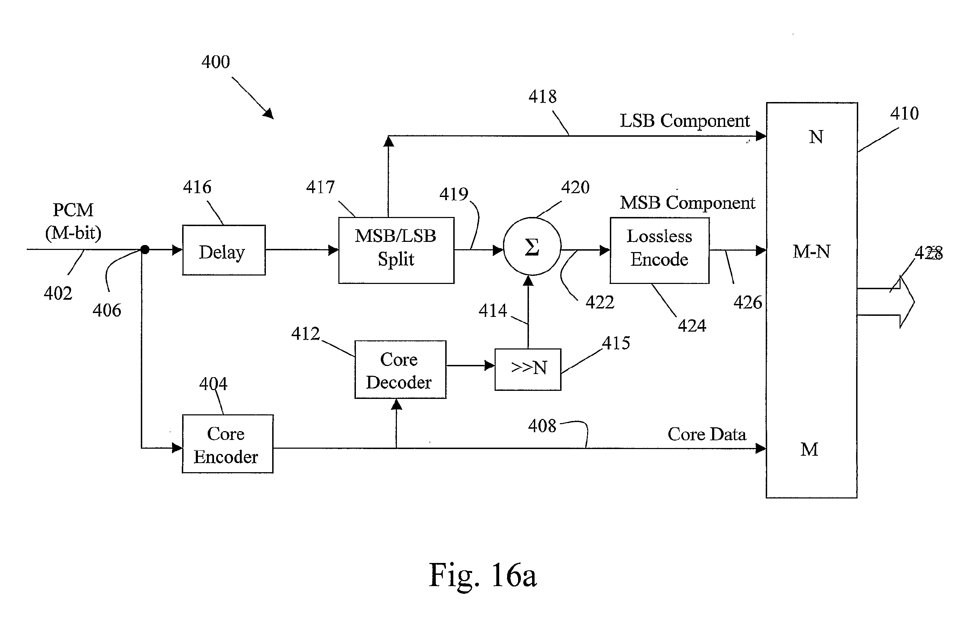

Figure 16a shows a system level view of a scalable backward compatible encoder **400.** A digitized audio signal, suitably M-bit PCM audio samples, is provided at input **402.** Preferably, the digitized audio signal has a sampling rate and bandwidth which exceeds that of a modified, lossy core encoder **404.** In one embodiment, the sampling rate of the digitized audio signal is 96 kHz (corresponding to a bandwidth of 48 kHz for the sampled audio). It should also be understood that the input audio may be, and preferably is, a multichannel signal wherein each channel is sampled at 96 kHz. The discussion which follows will concentrate on the processing of a single channel, but the extension to multiple channels is straightforward. The input signal is duplicated at node **406** and handled in parallel branches. In a first branch of the signal path, a modified lossy, wideband encoder **404** encodes the signal. The modified core encoder **404,** which is described in detail below, produces an encoded data stream (corestream **408)** which is conveyed to a packer or multiplexer **410.** The corestream **408** is also communicated to a modified corestream decoder **412,** which produces as output a modified, reconstructed core signal **414,** which is right shifted by N bits (>>N **415**) to discard its N lsbs.

Meanwhile, the input digitized audio signal **402** in the parallel path undergoes a compensating delay **416,** substantially equal to the delay introduced into the reconstructed audio stream (by modified encode and modified decoders), to produce a delayed digitized audio stream. The audio stream is split into MSB and LSB portions **417** as described above. The N-bit LSB portion **418** is conveyed to the packer **410.** The M-N bit reconstructed core signal **414,** which was shifted to align with the MSB portion, is subtracted from the MSB portion of the delayed digitized audio stream **419** at subtracting node **420.** (Note that a summing node could be substituted for a subtracting node, by changing the polarity of one of the inputs. Thus, summing and subtracting may be substantially equivalent for this purpose).

Subtracting node **420** produces a difference signal **422** which represents the difference between the M-N MSBs of the original signal and the reconstructed core signal. To accomplish purely "lossless" encoding, it is necessary to encode and transmit the difference signal with lossless encoding techniques. Accordingly, the M-N bit difference signal **422** is encoded with a lossless encoder **424,** and the encoded M-N bit signal **426** packed or multiplexed with the core stream **408** in packer **410** to produce a multiplexed output bitstream **428.** Note that the lossless coding produced coded lossless streams **418** and **426** which are at a variable bit rate, to accommodate the needs of the lossless coder. The packed stream is then optionally subjected to further layers of coding including channel coding, and then transmitted or recorded. Note that for purposes of this disclosure, recording may be considered as transmission through a channel.

The core encoder **404** is described as "modified" because in an embodiment capable of handling extended bandwidth the core encoder would require modification. A 64-band analysis filter bank within the encoder discards half of its output data and encodes only the lower 32 frequency bands. This discarded information is of no concern to legacy decoders that would be unable to reconstruct the upper half of the signal spectrum in any case. The remaining information is encoded as per the unmodified encoder to form a backwards-compatible core output stream. However, in another embodiment operating at or below 48 kHz sampling rate, the core encoder could be a substantially unmodified version of a prior core encoder. Similarly, for operation above the sampling rate of legacy decoders, the core decoder **412** would need to be modified as described below. For operation at conventional sampling rate (e.g., 48 kHz and below) the core decoder could be a substantially unmodified version of a prior core decoder or equivalent. In some embodiments the choice of sampling rate could be made at the time of encoding, and the encode and decode modules reconfigured at that time by software as desired.

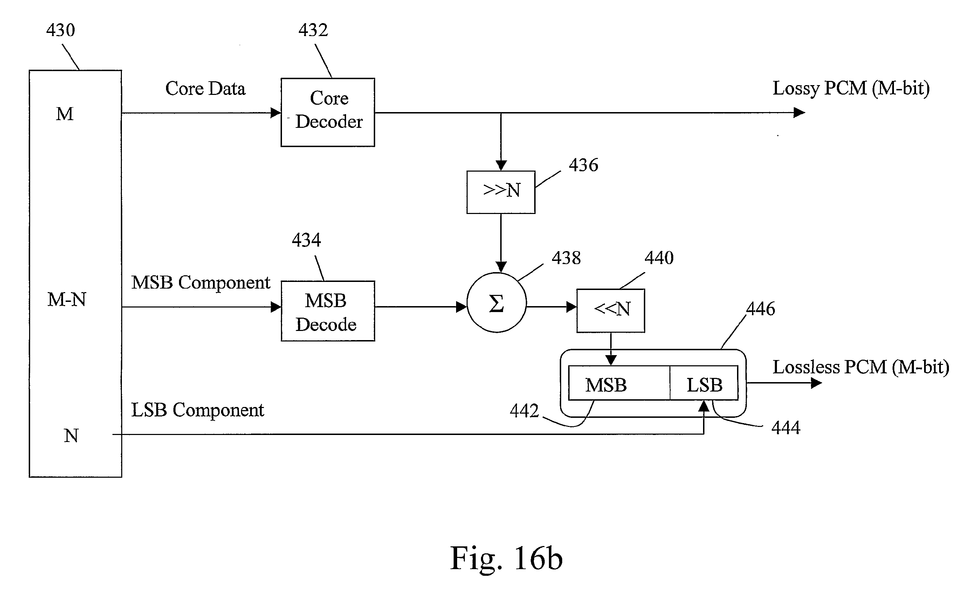

As shown in Figure 16b, the method of decoding is complementary to the method of encoding. A prio r generation decoder can decode the lossy core audio signal by simply decoding the corestream **408** and discarding the lossless MSB and LSB portions. The quality of audio produced in such a prior generation decoder will be extremely good, equivalent to prior generation audio, just not lossless.

Referring now to Figure 16b, the incoming bitstream (recovered from either a transmission channel or a recording medium) is first unpacked in unpacker **430,** which separates the corestream **408** from lossless extension data streams **418** (LSB) and **426** (MSB). The core stream is decoded by a modified core decoder **432,** which reconstructs the core stream by zeroing out the un-transmitted sub-band samples for the upper 32 bands in a 64-band synthesis during reconstruction. (Note, if a standard core encode was performed, the zeroing out is unnecessary). The MSB extension field is decoded by a lossless MSB decoder **434.** Because the LSB data was losslessly encoded using bit replication no decoding is necessary.

After decoding core and lossless MSB extensions in parallel, with the interpolated core reconstructed data is right shifted by N bits **436** and combined with the lossless portion of the data by adding in summer **438.** The summed output is left shifted by N bits **440** to form the lossless MSB portion **442** and assembled with the N-bit LSB portion **444,** to produce a PCM data word **446** that is a lossless, reconstructed representation of the original audio signal **402.**

Because the signal was encoded by subtracting a decoded, lossy reconstruction from the exact input signal, the reconstructed signal represents an exact reconstruction of the original audio data. Thus, paradoxically, the combination of a lossy codec and a losslessly coded signal actually performs as a pure lossless codec, but with the additional advantage that the encoded data remains compatible with prior generation, lossless decoders. Furthermore, the bitstream can be scaled by selectively discarding LSBs to make it conform to media bit rate constraints and buffer capacity.

While seve ral illustrative embodiments of the invention have been shown and described, numerous variations and alternate embodiments will occur to those skilled in the art. Such variations and alternate embodiments are contemplated, and can be made without departing from the spirit and scope of the invention as defined in the appended claims.

A method for authoring an audio bitstream on to a media according to the invention is defined in appended claim1. Further preferred features thereof are claimed in subclaims 2 and 3.

In addition to the claimed embodiment in the appended claims, the following is a list of additional embodiments which may serve as the basis for additional claims

### Embodiment 1

A method of encoding and authoring audio data, comprising: losslessly encoding the audio data in a sequence of analysis windows into a scalable bitstream; comparing a buffered payload for the encoded audio data to an allowed payload for each window; and scaling the losslessly encoded audio data in the non-conforming windows so that the buffered payload for the bitstream does not exceed the allowed payload, said scaling operation introducing loss into the encoded data in those windows.

### Embodiment 2

The method of embodiment 1, wherein the audio data is separated into most significant bit (MSB) and least significant (LSB) portions for each analysis window and encoded with different lossless algorithms.

### Embodiment 3

The method of embodiment 2, wherein the audio data is separated by; Assigning a minimum MS B bit width (Min MSB); Computing a cost function for the audio data in the analysis window; if the cost function exceeds a threshold, computing an LSB bit width of at least one bit that satisfies the Min MSB; and if the cost function does not exceed the threshold, assigning the LSB bit width, to be zero bits.

### Embodiment 4

The method of embodiment 3, further comprising; Computing a max LSB bit width (Max LSB) as the bit width of the audio data minus Min MSB;
Computing an L_{∞} norm as the maximum absolute amplitude of the audio data in the analysis window;
Computing Max Amp as the number of bits needed to represent a sample with val-ue equal to -L_{∞},
Computing a squared L2 norm as the sum of the squared amplitudes of the audio data in the analysis window;
If Max Amp does not exceed Min MSB and the L2 norm does not exceed a threshold, setting the LSB bit width to zero bits;
If Max Amp does not exceed Min MSB but the L2 norm does exceed the threshold, setting the LSB bit width to the Max LSB bit width divided by a scaling factor; If Max Amp exceeds the Min MSB, setting the LSB bit width to the Max Amp minus Min MSB.

### Embodiment 5

The method of embodiment 4 , wherein the LSB bit width is limited to a maximum LSB bit width (Max LSB) determined by a word width of the audio data and Min MSB.

### Embodiment 6

The method of embodiment 2 , wherein an LSB bit width and the encoded MSB and LSB portions are packed into a bitstream for each analysis window.

### Embodiment 7

The method of embodiment 2, wherein the MSB portion is encoded with a lossless algorithm that includes decorrelation between multiple audio channels and adaptive prediction within each audio channel.

### Embodiment 8

The method of embodiment 2, wherein the LSB portion is encoded with a lossless algorithm that replicates the bits for the PCM samples.

### Embodiment 9

The method of embodiment 2, wherein the LSB portion is encoded with a lossless algorithm that uses low order prediction and entropy coding.

### Embodiment 10

The method of embodiment 2, wherein the analysis windows are frames, each frame comprising a header for storing the LSB bit widths and one or more segments, each segment comprising one or more channel sets, each channel set comprising one or more audio channels, each channel comprising one or more frequency extensions, said lowest frequency extension including encoded MSB and LSB portions.

### Embodiment 11

The method of embodiment 10, wherein the bitstream has a distinct MSB and LSB split for each. channel in each channel set in each frame.

### Embodiment 12

The method of embodiment 11, wherein said higher frequency extensions include only encoded LSB portions.

### Embodiment 13

The method of embodiment 2, wherein, the bitstream is authored by, Packing the losslessly encoded MSB portions into the bitstream for all the windows; Packing the losslessly encoded LSB portions into the bitstream for the conforming windows;
Scaling the losslessly encoded LSB portions for any non-conforming windows to make them conform; and
Packing the now lossy encoded LSB portions for the now conforming windows into the bitstream.

### Embodiment 14

The method of embodiment 13, wherein the LSB portions are scaled by, calculating an LSB bit width reduction for the analysis window; decoding the LSB portions in the non-conforming windows;
reducing the LSB portions by the LSB bit width reduction by discarding that number of LSBs; encoding the modified LSB portions with the lossless 10 encoding algorithm; packing the encoded LSB portions; and packing the modified LSB bit widths and the LSB bit width reduction into the bitstream.

### Embodiment 15

The method of embodiment 14, wherein the lossless encoding is simple bit replication, wherein the LSB portions are reduced by, adding dither to each LSB portion so as to dither 5 the next LSB past the LSB bit width reduction; and shifting the LSB portion to the right by the LSB bit width reduction.

### Embodiment 16

The method of embodiment 14, wherein the LSB bit width reduction is just enough that the buffered payload does not exceed the allowed payload.

### Embodiment 17

The method of embodiment 14, wherein the audio data includes multiple channels, said LSB bit width reduction being calculated for each channel in accordance with a channel prioritization rule.

### Embodiment 18

A method of encoding a scalable, lossless bitstream for audio data, comprising: determining a breakpoint that separates audio data into an MSB and an LSB portion for an analysis window; 5 losslessly encoding the MSB portions; losslessly encoding the LSB portions; packing the encoded MSB portions and LSB portions into a lossless bitstream; and packing the bit widths of the LSB portions into the 10 lossless bitstream.

### Embodiment 19

The method of embodiment18, wherein the breakpoint is determined by; Assigning a minimum MSB bit width (Min MSB); Computing a cost function for the audio data in the analysis window; if the cost function exceeds a threshold, computing an LSB bit width of at least one bit that satisfies the Min MSB; and if the cost function does not exceed the threshold, assigning the LSB bit width to be zero bits.

### Embodiment 20

The method of embodiment 18, wherein the LSB portions are encoded with a lossless algorithm that replicates the bits of the audio data.

### Embodiment 21

An article of manufacture comprising a bitstream separated into a sequence of analysis windows of encoded audio data stored on a media, the audio data in each said analysis window being losslessly encoded except as necessary to reduce the buffered payload of said analysis window to no more than an allowed payload.

### Embodiment 22

The article of manufacture of embodiment 21, wherein some of the analysis windows include losslessly encoded MSB and LSB portions and the remaining analysis windows include losslessly encoded MSB portions and lossy encoded LSB portions.

### Embodiment 23

The article of manufacture of embodiment 22, wherein the bitstream includes header information containing the modified bit widths of the LSB portions and the bi-t width reduction of the LSB portions.

### Embodiment 24

The article of manufacture of embodiment 23, wherein the LSB portions are losslessly and lossy encoded using bit replication.

### Embodiment 25

The article of manufacture of embodiment 24, wherein the bit width reduction of the LSB portions is just enough that the buffered payload does not exceed the allowed payload.

### Embodiment 26

A method of decoding an audio bitstream, comprising: receiving a bitstream as a sequence of analysis windows comprising header information including an LSB bit width and an LSB bit width reduction and audio data including losslessly encoded MSB portions and eithex losslessly encoded or scaled LSB portions so that a buffered payload of each analysis window is within an allowed payload; extracting the LSB bit width and the LSB bit widtb reduction for each analysis window; extracting the losslessly encoded MSB portions and decoding them into PCM audio data; extracting either the losslessly encoded or scaled LSB portions and decoding them into PCM audio data; assembling the MSB and LSB portions for ea ch PCM audio sample; using the LSB bit width and LSB bit width reduction to translate the assembled PCM audio data to an original bit width word; and outputting the PCM audio data for each analysis window.

### Embodiment 27

The method of embodiment 26, wherein the losslessly encoded and scaled LSB portions are decoded by bit replication.

### Embodiment 28

A decoder chip configured to receive a bitstream and output PCM audio data, said chip configured to execute the steps of: extracting an LSB bit width and an LSB bit width reduction for each analysis window in the bitstream; extracting losslessly encoded MSB portions and decoding them into PCM audio data; extracting either losslessly encoded or scal-ed LSB portions and decoding them into PCM audio data; assembling the MSB and LSB portions for ea-ch PCM audio sample; using the LSB bit width and LSB bit width reduction to translate the assembled PCM audio data to an oxiginal bit width word; and outputting the PCM audio data for each analysis window.

### Embodiment 29

An audio decoder, comprising: a controller for reading encoded audio data from a bitstream on a media; a buffer for buffering a plurality of analysis windows of the encoded audio data; and a DSP chip for decoding the encoded audio data and outputting PCM audio data for each successive analysis window, said DSP chip configured to decode analysis windows comprising header information including LSB bit widths and LSB bit width reductions and audio data including losslessly encoded MSB portions and losslessly encoded or scaled LSB portions, wherein the buffered payload does not exceed an allowed payload determined by the peak bit rate supported by the media and the capacity of the buffer.

### Embodiment 30

The audio decoder of embodiment 32, wherein the DSP chip executes the steps of: extracting the LSB bit width and the LSB bit width reduction for each analysis window in the bitstream; extracting the losslessly encoded MSB portions and decoding them into PCM audio data; extracting either the losslessly encoded or the scaled LSB portions and decoding them into PCM audio data; assembling the MSB and LSB portions for each PCM audio sample; using the LSB bit width and LSB bit width reduction to translate the assembled PCM audio data to an original bit width word; and outputting the PCM audio data for each analysis window.

### Embodiment 31

A method of encoding a scalable, lossless bitstream for M-bit audio data that is backward compatible with a lossy core decoder, comprising: encoding the M-bit audio data into a lossy M-bit corestream; packing the lossy M-bit corestream into a bitstream; decoding the M-bit corestream into a reconstructed core signal; separating the M-bit audio data into M-N bit MSB and N-bit LSB portions; packing the N-bit LSB portion into the bitstream; right shifting the reconstructed core signal by N bits to align it with the MSB portion; subtracting the reconstructed core signal from the MSB portion to form an M-N bit residual signal; losslessly encoding the residual signal; packing the encoded residual signal into the bitstream; and packing the bit widths of the LSB portions into the lossless bitstream.

### Embodiment 32

The method of embodiment 31, further comprising adding dither to the reconstructed core signal prior to right shifting and packing a dither parameter into the bitstream.

## Claims

1. A method of authoring an audio bitstream onto a media comprising:
a) determining a scheme for laying out the encoded audio data from a bitstream onto a media for a decoder buffer, said bitstream including losslessly encoded MSB and LSB portions in a sequence of analysis windows;
b) calculating a buffered payload for the encoded audio data for the next analysis window;
c) if the buffered payload is within an allowed payload for an analysis window, packing the losslessly encoded MSB and LSB portions into a modified bitstream;
d) if the buffered payload exceeds the allowed payload for an analysis window, packing the losslessly encoded MSB portion into the modified bitstream; scaling the losslessly encoded LSB portion to a lossy encoded LSB portion so that the buffered payload is within the allowed payload; and
packing the lossy encoded LSB portion into the modified bitstream with its scaling information; and
e) repeating steps b through d for each analysis window..

2. The method of claim 1, wherein the LSB portions are scaled by
calculating an LSB bit width reduction for the analysis window;
decoding the LSB portions in the non-conforming windows;
reducing the LSB portions by the LSB bit width reduction by discarding that number of LSBs;
encoding the modified LSB portions with the lossless encoding algorithm;
packing the encoded LSB portions; and
packing the modified LSB bit widths and the LSB bit width reduction into the bitstream.

3. The method of claim 2 wherein the lossless encoding and decoding is simple bit replication, wherein the LSB portions are reduced by
adding dither to each LSB portion so as to dither the next LSB past the LSB bit width reduction; and
shifting the LSB portion to the right by the LSB bit width reduction.
